Europäisches Patentamt

(19) European Patent Office

Office européen des brevets

(11) Publication number: **0 058 289**
**A1**

## (12) EUROPEAN PATENT APPLICATION

(21) Application number: 81830177.2

(22) Date of filing: 30.09.81

(51) Int. Cl.³: **H 03 J 9/06**
**H 01 Q 3/02**

(30) Priority: 16.02.81 IT 1976981

(43) Date of publication of application:
25.08.82 Bulletin 82/34

(84) Designated Contracting States:
AT BE CH DE FR GB LI LU NL

(71) Applicant: BRIONVEGA S.p.A.
Via Pordenone, 8
I-20132 Milano(IT)

(72) Inventor: Banfi, Francesco
Via Manzoni, 14
I-20059 Vimercate (Milan)(IT)

(74) Representative: Zini, Alessandro
Ufficio Tecnico Internazionale Brevetti Ing. Alessandro
Zini Piazza Castello 1
I-20121 Milano(IT)

(54) Arrangement for the automatic orientation of an antenna in a radio receiver or television set by means of a telecontrol.

(57) An arrangement for the automatic orientation of an antenna (20) in a radio receiver or television set comprises a telecontrol transmitter (1) and a circuitry inside the apparatus consisting of a receiver (6) for the signals emitted by the telecontrol (1), a register (14) and a digital/analog converter (16) which supplies a variable voltage to each value of which an angular position of the antenna (20) can be associated.

The signals emitted by the telecontrol (1) can be stored in a memory (13) incorporated in the apparatus and the information relating to an angular position of the antenna can be associated, in the case of a key controlled television set or radio receiver, each to an individual channel.

EP 0 058 289 A1

./...

SERVO CONTROL FOR THE ORIENTATION OF THE ANTENNA

CIRCUITS INSIDE THE TELEVISION SET

0058289

- 1 -

<u>Arrangement for the automatic orientation of an antenna</u>
<u>in a radio receiver or television set by means of a te-</u>
<u>lecontrol</u>

The present invention relates to an arrangement for the automatic orientation of an antenna in a radio receiver or television set.

Although the invention can be applied also to radio receivers, it lends itself particularly to the use in television sets and therefore it will be described by way of example in connection with television sets.

The reception of a number of television transmitters by means of signals from different directions requires often the use of several antennas with different orientation or as an alternative of an antenna orientable by means of a servo control. In the wide-spread case of the use of a non centralized antenna the user must search, at any channel change, for the most suitable orientation for the signal reception.

The performances of the present day television sets provided with a telecontrol for channel change, are therefore partly limited by the requirement that the orientation of the antenna must be changed frequently when a channel change is effected, which operation has been made manually up to now.

The present invention aims to obviate such a disadvantage.

More particularly, the arrangement for the automatic orientation of an antenna according to the invention is characterized in that it comprises a telecontrol transmitter and a circuitry inside the apparatus provided with an orientable antenna, consisting of a receiver for the signals emitted by the telecontrol, a decoder and a digital/analog converter whose output is connected to a servo control for the orientation of the antenna.

The digital/analog converter supplies a variable voltage to each value of which an angular position of the antenna can be associated. The obtainable angular resolution depends on the cell (bit) number of the register used.

The antenna can be either an outdoor antenna equiped with a servo control or an antenna incorporated in the radio receiver or television set.

According to a feature of the invention, for the positioning of the antenna one of the proportional controls (volume change, contrast control, etc.) of the same telecontrol can be used advantageously.

According to another feature of the invention, the rotation of the antenna can be remotely controlled to associate to each channel the most suitable orientation of the antenna and this orientation is stored for each channel so that at any subsequent channel change the antenna moves automatically in the right position previously fixed once and for all.

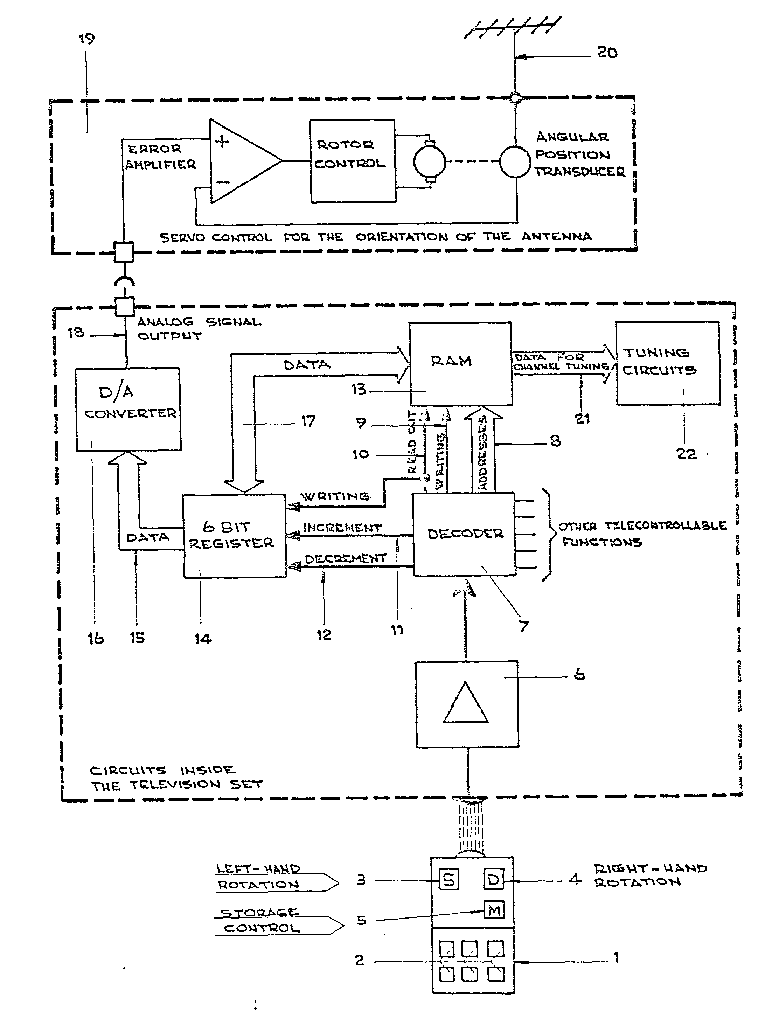

These and other features of the invention will be better apparent from the following detailed description, given merely by way of example and therefore in no limiting sense, of an embodiment thereof, referring to the accompanying drawing, whose single figure shows diagrammatically an arrangement according to the invention.

From said figure there is seen that in a telecontrol transmitter 1, in addition to the keys 2 intended for the channel change and the keys for the adjustment of the various parameters of the television set, the keys 3 and 4 have been incorporated for the left-hand and right-hand rotation of the antenna in order to search, for each channel, for the orientation giving an optimal reception. The storage key 5, normally already present to associate to each program key a channel according to the user's choice, has in this case also the function of associating to each channel the optimal orientation of the antenna previously chosen by the user by means of the keys 3 and 4.

The signals transmitted by the telecontrol are received and amplified by the amplifier 6 and sent to the decoder 7 which, in addition to supplying the usual signals for controlling the various parameters of the television set, is connected both to a random access memory (RAM) 13 by means of a data addressing bus 8 and writing and read out control lines 9 and 10 respectively and to a six or more bit register 14 by means of increment and decrement signal lines 11 and 12 respectively. In addition, the line 10, while acting for the read out signals for RAM 13 acts simultaneously as writing signal for the register 14.

The register 14 is connected to a digital/analog converter 16 by means of a data bus 15 and to the memory 13 by means of the  bidirectional data bus 17.

From the converter D/A 16 an analog signal 18 goes · out whose value determines the angular position, and thus the orientation,of the antenna 20 by means of the servo control 19.

In order to understand the operation of the arrangement, let us examine hereinafter the various modes of use:

a) Control of the left-hand and right-hand rotation of the antenna by means of the push-buttons 3 and 4  to search for the optimal orientation of the antenna for the reception channel chosen by means of one of the keys 2.

When choosing a channel, by means of one of the keys 2, there goes out through the bus 8 from the decoder a predetermined address for the memory 13 which, through the bus 21, tunes the television set on the desired channel by means of the circuits 22.

Simultaneously, the random data present in the memory cell corresponding to the requested channel, are transferred through the bidirectional bus 17 to the register 14 by means of a  timed control applied on the line 10.

Once this control has ceased, the output from the memory 13 changes to the high impedance condition and does not influence the contents of the register 14 any longer.

The antenna will have taken in the meantime a random position (if no specific data has been previously stored) and therefore requires a manual adjustment. In this case, by acting on the control keys 3 and 4, the corresponding signals radiated by the telecontrol 1, amplified by 6 and decoded by 7 arrive to the register 14 by means of the lines 11 and 12 and cause a gradual increment or decrement with respect to the existing digital value.

The corresponding digital data pass from the register to the converter D/A 16 through the data bus 15. From the converter D/A an analog signal 18 goes out which, through the servo control 19, rotates the antenna in a real time rightwards and leftwards corresponding to the controls given by means of the keys 3 and 4.

b) <u>Storage of the angular position of the antenna</u> and its association to the channel being received.

If, after having chosen a signal by means of one of the keys 2 and having searched for the angular position of the antenna for best reception of the signal by means of the keys 3 and 4, the storage control 5 is pushed down, the corresponding signal, received by 6 and decoded by 7, enables, through the line 9, the memory RAM 13 to store the data existing on the register 14 corresponding to the angular position of the antenna and present on the bidirectional bus 17.

These data are stored in the memory cell relating to the memory address imposed by the bus 8 and corresponding to the channel being received.

c) Call for the channel on which an angular position of the antenna has been previously stored.

In this case by calling for the channel by means of one of the keys 2 the desired signal, amplified by 6 and decoded by 7, supplies the memory with the read out control of the memory cell corresponding to the address communicated by means of 8.

In this memory cell, in addition to the data corresponding to the channel called for, which tune the television set through the bus 21, there are now also the data relating to the optimal angular position of the antenna. These data are transferred through the bus 17 in the register 14 and from it they pass to the converter D/A 16 through the bus 15 and there appears on 18 the analog signal for the control of the servo control 19.

While but one embodiment of the invention has been illustrated and described, it is obvious that a number of changes and modifications can be made without departing from the scope of the invention. In particular the present invention can be used also in combination with the arrangement for the remote change over of two or more antenna terminals of a television set, disclosed in the applicant's Italian patent application No.19580 A/80 of January 31, 1980 so as to control, in addition to the antenna change over, also the positioning of the antenna with the possibility of storing both controls for each
channel.

0058289

Claims

1. An arrangement for the automatic orientation of an antenna in a radio receiver or television set, characterized in that it comprises a telecontrol transmitter and a circuitry inside the apparatus provided with an orientable antenna, consisting of a receiver for the signals emitted by the telecontrol, a decoder, a register and a digital/analog converter whose output is connected to a servo control for the orientation of the antenna.

2. An arrangement as claimed in claim 1, characterized in that the circuitry inside the apparatus comprises a random access memory connected to the decoder and the register.

3. An arrangement according to claim 1 or 2, characterized in that the control members of the telecontrol transmitter used for the rotation of the antenna are the same control members used for one of the proportional controls of the apparatus such as the volume control, the contrast control and the like.

4. An arrangement as claimed in claim 2, characterized in that the memory, the register and the digital/analog converter used for the rotation of the antenna are sections of the memory, register and digital/analog converter already present in the telecontrol system of the apparatus.

5. An arrangement as claimed in any of the preceding claims, characterized in that the orientable antenna is an antenna incorporated or incorporatable in the apparatus and the servo control for the control of the antenna is incorpo-

0058289

rated or incorporatable in the apparatus.

6. An arrangement as claimed in any of the claims 1 to 4, characterized in that the orientable antenna is an outdoor antenna provided with a servo control.

0058289

**European Patent Office**

**EUROPEAN SEARCH REPORT**

Application number

EP 81 83 0177

| | DOCUMENTS CONSIDERED TO BE RELEVANT | | | CLASSIFICATION OF THE APPLICATION (Int. Cl. 3) |
|---|---|---|---|---|
| Category | Citation of document with indication, where appropriate, of relevant passages | | Relevant to claim | |
| Y | FR - A - 2 437 111 (INDESIT) | | | H 03 J 9/06 |
| | * Figures 1,2; page 1, line 10 - page 2, line 25; page 4, line 1 - page 8, line 29 * | | 1-6 | H 01 Q 3/02 |
| | & GB - A - 2 033 179 (14-05-1980) | | | |
| | -- | | | |
| Y | ELECTRONICS, May 13, 1976, New York, US M. LORKOVIC: "MOS technology brings fun and games to TV sets", pages 87-92 | | | |
| | | | | **TECHNICAL FIELDS SEARCHED (Int.Cl. 3)** |
| | * Figures 1,4; page 87, column 2, line 29 - page 89, column 1, line 4; page 91, column 1, line 14 - page 92, column 1, line 25 * | | 1-6 | H 03 J |
| | | | | H 04 B |
| | | | | H 01 Q |
| | -- | | | |
| Y | US - A - 4 072 886 (N.E. DAMMEYER) | | | |
| | * Figures 1,2,5; column 1, line 36 - column 2, line 53; column 3, line 11 - column 4, line 2 * | | 1-4,6 | |
| | -- | | | |
| A | US - A - 3 508 274 (R.B. KESLER et al.) | | | **CATEGORY OF CITED DOCUMENTS** |
| | * Figures 1,6; column 1, line 30 - column 1, line 72; column 2, line 56 - column 3, line 18; column 4, line 31 - column 4, line 48 * | | 1,5 | X: particularly relevant if taken alone Y: particularly relevant if combined with another document of the same category A: technological background O: non-written disclosure P: intermediate document T: theory or principle underlying the invention E: earlier patent document, but published on, or after the filing date D: document cited in the application L: document cited for other reasons |
| | -- | | | |
| A | DE - A - 2 401 860 (H. PAGEL) | | | |
| | ---- | | | |
| | | | | &: member of the same patent family, corresponding document |

| X | The present search report has been drawn up for all claims | |
|---|---|---|
| Place of search The Hague | Date of completion of the search 18-03-1982 | Examiner RATAJSKI |

EPO Form 1503.1  06.78